# EUROPEAN PATENT APPLICATION

(11) **EP 2 849 236 A1**
(43) Date of publication of application: **18.03.2015**
(21) Application number: 14167747.6
(22) Date of filing: 09.05.2014
(51) Int. Cl.: H01L 33/04, H01L 33/10, H01L 33/12

(54) **Light-emitting diode**

(30) Priority: 13.09.2013 TW 102133131
(71) Applicant: Lextar Electronics Corp., 30075 Hsinchu (TW)
(72) Inventor: Chou, Hsiu-Mei, 300 Hsinchu City (TW); Chu, Jui-Yi, 420 Taichung City (TW)
(74) Representative: Fuchs Patentanwälte Partnerschaft mbB

(57) **Abstract**

The present disclosure provides a light-emitting diode, including: a silicon substrate having a first surface and a second surface opposite to the first surface; a buffer layer disposed over the first surface of the substrate, wherein the buffer layer includes alternating SiC and InₓAl_{y}Ga_{(1-x-y)}N layers, wherein 0 ≤ x ≤ 1, 0 ≤ y ≤ 1, and 0 ≤ (x+y) ≤ 1 and one of the SiC layers directly contacts the substrate; a first semiconductor layer disposed over the buffer layer and having a first conductive type; an active layer disposed over the first semiconductor layer; and a second semiconductor layer disposed over the active layer and having a second conductive type different from the first conductive type.

## Description

### CROSS REFERENCE TO RELATED APPLICATIONS

This application claims priority of Taiwan Patent Application No. 102133131, filed on September, 13, 2013, the entirety of which is incorporated by reference herein.

### BACKGROUND

### Technical Field

The disclosure relates to a light-emitting diode, and in particular to a light-emitting diode having a buffer layer.

### Description of the Related Art

A light-emitting diode is fabricated by forming an active layer over a substrate and depositing various conductive and semiconductive layers over the substrate. The recombination radiation of electron and hole may produce electromagnetic radiation (such as light) through the current at the p-n junction. For example, in the forward bias p-n junction formed by direct band gap materials such as GaAs or GaN, the recombination of electron and hole injected into the depletion region results in electromagnetic radiation. The aforementioned electromagnetic radiation may lie in the visible region or the non-visible region. Materials with different band gaps may be used to form light-emitting diodes with different colors.

The sapphire substrate is widely used in the high power light-emitting diode developed in recent years. However, since the high power light-emitting diode must be operated under high current such as 350mA, lots of heat will be produced and accumulate in the substrate when the high power light-emitting diode is operated. Since the heat cannot be effectively exhausted out of the sapphire light-emitting diode, the luminous efficiency of the sapphire light-emitting diode will decrease due to the overheating. Therefore, the sapphire high power light-emitting diodes have not yet been popularized as general illumination products.

The heat produced by the sapphire high power light-emitting diode cannot be effectively exhausted due to the poor thermal conductivity of the sapphire substrate (30W/K·m). Moreover, the high cost and complex process of the sapphire substrate make it difficult to achieve mass production. Therefore, a light-emitting diode, which is cost-effective and has high thermal conductivity and high luminous efficiency, is needed.

### SUMMARY

The present disclosure provides a light-emitting diode, including: a silicon substrate having a first surface and a second surface opposite to the first surface; a buffer layer disposed over the first surface of the substrate, wherein the buffer layer includes alternating SiC and InₓAl_{y}Ga_{(1-x-y)}N layers, wherein 0 ≤ x ≤ 1, 0 ≤ y ≤ 1, and 0 ≤ (x+y) ≤ 1 and one of the SiC layers directly contacts the substrate; a first semiconductor layer disposed over the buffer layer and having a first conductive type; an active layer disposed over the first semiconductor layer; and a second semiconductor layer disposed over the active layer and having a second conductive type different from the first conductive type.

A detailed description is given in the following embodiments with reference to the accompanying drawings.

### BRIEF DESCRIPTION OF THE DRAWINGS

The disclosure may be more fully understood by reading the subsequent detailed description and examples with references made to the accompanying drawings, wherein:
Fig. 1 is a cross-sectional view of a light-emitting diode in accordance with some embodiments of the present disclosure;
Fig. 2 is a cross-sectional view of a light-emitting diode in accordance with other embodiments of the present disclosure;
Fig. 3 is a relation graph of the number of alternating SiC and AlN layers and the reflectivity of the buffer layer; and
Fig. 4 is a picture of a buffer layer with dislocation taken by a microscope.

### DETAILED DESCRIPTION

In the following detailed description, for purposes of explanation, numerous specific details are set forth in order to provide a thorough understanding of the disclosed embodiments. It will be apparent, however, that one or more embodiments may be practiced without these specific details. In other instances, well-known structures and devices are schematically shown in order to simplify the drawing.

In this specification, expressions such as "overlying the substrate", "above the layer", or "on the film" simply denote a relative positional relationship with respect to the surface of a base layer, regardless of the existence of intermediate layers. Accordingly, these expressions may indicate not only the direct contact of layers, but also, a non-contact state of one or more laminated layers. It is noted that in the accompanying drawings, like and/or corresponding elements are denoted by like reference numerals.

It will be understood that, although the terms first, second, third etc. may be used herein to describe various elements, components, regions, layers and/or sections, these elements, components, regions, layers and/or sections should not be limited by these terms. These terms are only used to distinguish one element, component, region, layer or section from another region, layer or section. Thus, a first element, component, region, layer or section discussed below could be termed a second element, component, region, layer or section without departing from the teachings of the present invention.

Unless defined otherwise, all technical and scientific terms used herein have the same meaning as commonly understood to one of ordinary skill in the art to which this invention belongs. It should be appreciated that each term, which is defined in a commonly used dictionary, should be interpreted as having a meaning conforming to the relative skills and the background or the context of the present disclosure, and should not be interpreted by an idealized or overly formal manner unless defined otherwise.

The terms "about" and "substantially" typically means +/- 20% of the stated value, more typically +/- 10% of the stated value and even more typically +/- 5% of the stated value. The stated value of the present disclosure is an approximate value. When there is no specific description, the stated value includes the meaning of "about" or "substantially".

The light-emitting diode provided in the present disclosure utilizes a Si substrate, which has high thermal conductivity and is cost-effective, and a buffer layer disposed between the Si substrate and a semiconductor layer enables a light-emitting diode with excellent thermal conductivity, low cost, good film quality of the semiconductor layer and high reflectivity of the buffer layer.

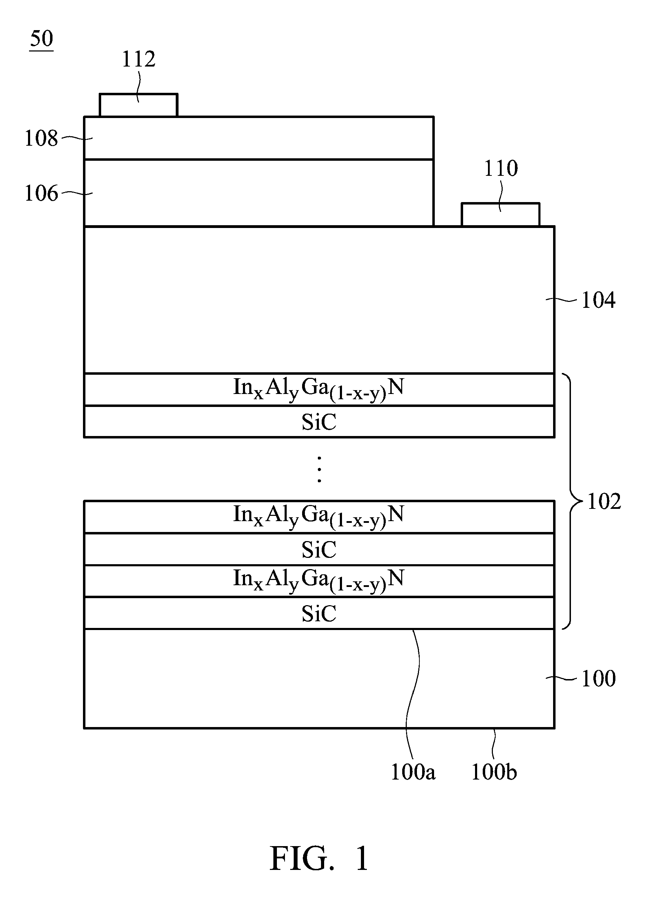

Referring to Fig. 1A, the light-emitting diode 50 may include a silicon substrate 100 having a first surface 100a and a second surface 100b opposite to the first surface 100a. Comparing to the sapphire substrate (thermal conductivity: 30W/K·m), the silicon substrate of the present disclosure has better thermal conductivity (150W/K·m). Therefore, when the silicon substrate of the present disclosure is utilized in the high power light-emitting diode, the produced heat may be effectively exhausted such that the luminous efficiency of the high power light-emitting diode will not decrease due to the over accumulation of heat. Moreover, the silicon substrate is low-cost. Compared to the sapphire substrate which is not cost-effective, the silicon substrate may reduce the cost by 75%. Therefore, usage of the silicon substrate may facilitate the mass production.

Conventionally, the utilization of the silicon substrate in the light-emitting diode faces two issues. First, the thermal expansion coefficients of the silicon substrate and the semiconductor layer are different and a lattice mismatch exists between the silicon substrate and the semiconductor layer. Therefore, a stress exists in the semiconductor layer formed on the silicon substrate, resulting in issues such as a bending or fracture of the semiconductor layer or the non-uniform thickness of the semiconductor layer. Second, the silicon substrate will absorb a portion of the blue light emitted by the light-emitting diode, which reduces the luminous efficiency of the light-emitting diode. The conventional solution for this issue is to replace the silicon substrate with a substrate which does not absorb blue light in the latter stage of the manufacturing process, or alternatively, to form a high reflectivity metal layer and bond another silicon substrate to the high reflectivity metal layer of the light-emitting diode in the latter stage of the manufacturing process. However, these two solutions both increase the cost and decrease the yield. To effectively solve the aforementioned issues in the meantime, the present disclosure forms a buffer layer having high reflectivity and high buffer ability over the silicon substrate.

As illustrated in Fig. 1, a buffer layer 102 is disposed over the first surface 100a of the silicon substrate 100. The buffer layer 102 serves to promote the quality of the subsequent first semiconductor layer 104. Moreover, the buffer layer 102 also serves to reflect the light emitted toward the silicon substrate 100 when the light-emitting diode 50 is operated such that the light emitted toward the silicon substrate 100 is reflected and emitted out of the light-emitting diode 50, which in turn, increases the luminous efficiency of the light-emitting diode 50.

The buffer layer 102 may include alternating SiC and InₓAl_{y}Ga_{(1-x-y)}N layers, wherein 0 ≤ x ≤ 1, 0 ≤ y ≤ 1, and 0 ≤ (x+y) ≤ 1. Moreover, one of the SiC layers directly contacts the silicon substrate 100. In some embodiments of the present disclosure, the InₓAl_{y}Ga_{(1-x-y)}N layer may include, but is not limited to, GaN, InN, AlN, In_{0.5}Ga_{0.5}N, Al_{0.5}Ga_{0.5}N, Al_{0.5}In_{0.5}N, Al_{0.3}In_{0.3}Ga_{0.4}N or any other suitable materials. The buffer layer 102 may be formed by metalorganic chemical vapor deposition (MOCVD), Metalorganic vapor phase epitaxy (MOVPE), plasma-enhanced chemical vapor deposition (plasma-enhanced CVD), remote plasma-enhanced chemical vapor deposition (RP-CVD), molecular beam epitaxy (MBE), hydride vapor phase epitaxy (HVPE), liquid phase epitaxy (LPE), chloride vapor phase epitaxy (Cl-VPE), or any other suitable epitaxy process. Moreover, the buffer layer 102 may completely cover the silicon substrate 100 or may only cover a portion of the silicon substrate 100. For example, as illustrated in Fig. 1, the buffer layer 102 may completely cover the silicon substrate 100.

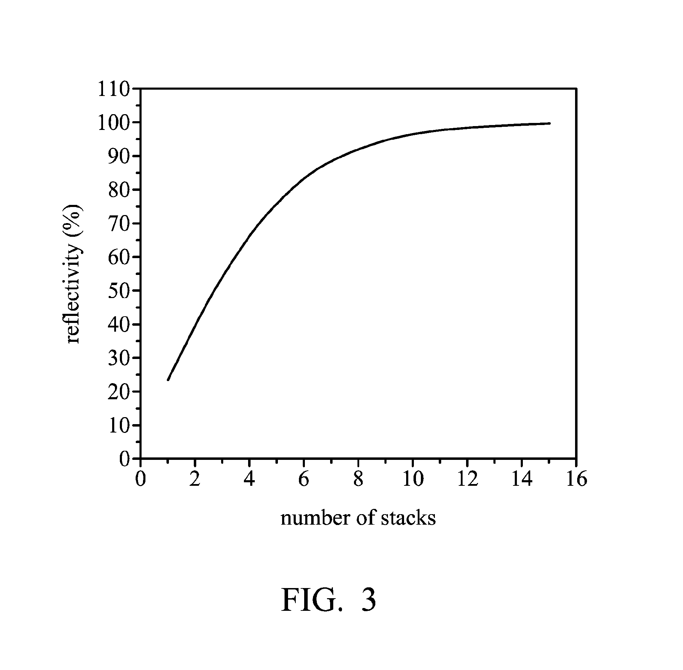

The SiC layers and the InₓAl_{y}Ga_{(1-x-y)}N layers of the buffer layer 102 have different refractive indexes, and therefore, the alternating SiC and InₓAl_{y}Ga_{(1-x-y)}N layers substantially function as a distributed Bragg reflector. The number of alternating SiC and InₓAl_{y}Ga_{(1-x-y)}N layers is related to the reflectivity of the buffer layer 102. The more the number of alternating SiC and InₓAl_{y}Ga_{(1-x-y)}N layers, the higher the reflectivity of the buffer layer 102. The buffer layer 102 may include 4-25 pairs of the alternating SiC and InₓAl_{y}Ga_{(1-x-y)}N layers and the reflectivity of the buffer layer 102 may range from about 70% to 100%. For example, in some embodiments of the present disclosure, the buffer layer 102 may include 5-20 pairs of the alternating SiC and InₓAl_{y}Ga_{(1-x-y)}N layers and the reflectivity of the buffer layer 102 may range from about 80% to 99.99%. Fig. 3 is a relation graph of the number of alternating SiC and AlN layers and the reflectivity of the buffer layer. As illustrated in Fig. 3, when the buffer layer 102 includes 4 pairs of the alternating SiC and AlN layers, the reflectivity of the buffer layer 102 is about 70%. When the buffer layer 102 includes 7 pairs of the alternating SiC and AlN layers, the reflectivity of the buffer layer 102 is about 90%. Since the light emitted toward the silicon substrate 100 is reflected and emitted out of the light-emitting diode 50, the luminous efficiency of the light-emitting diode 50 may be increased. Moreover, the thickness of each of the SiC layers or the InₓAl_{y}Ga_{(1-x-y)}N layers may range from about 1nm to 20nm, preferably from about 5nm to 10nm. The total thickness of the buffer layer 102 may range from about 5nm to 4µm, preferably from about 20nm to 1µm.

In some embodiments of the present disclosure, the buffer layer 102 is an N-type buffer layer and includes 5 pairs of the alternating N-doped SiC and Si-doped InₓAl_{y}Ga_{(1-x-y)}N layers (the N doping concentration and the Si doping concentration are 2x10¹⁹/cm³) to provides a reflectivity of 74.78%.

In other embodiments of the present disclosure, the buffer layer 102 is an P-type buffer layer and includes 12 pairs of the alternating Al-doped SiC and Mg-doped InₓAl_{y}Ga_{(1-x-y)}N layers (the Al doping concentration and the Mg doping concentration are 10¹⁸/cm³) to provides a reflectivity of 99.27%.

In other embodiments of the present disclosure, the buffer layer 102 is an P-type buffer layer and includes 20 pairs of the alternating B-doped SiC and Mg-doped InₓAl_{y}Ga_{(1-x-y)}N layers (the B doping concentration and the Mg doping concentration are 2x10²⁰/cm³) to provides a reflectivity of 99.99%.

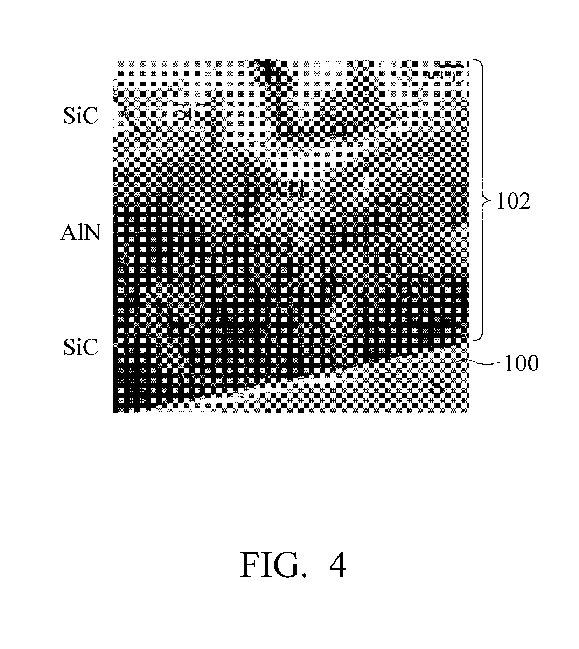

Moreover, the alternating configuration of the SiC layers and the InₓAl_{y}Ga_{(1-xy)}N layers may reduce the dislocation density in the buffer layer 102. For example, as illustrated in Fig. 4, the dislocation formed in the SiC layer which directly contacts the silicon substrate will stop at the interface of this SiC layer and the next InₓAl_{y}Ga_{(1-x-y)}N layer. Therefore, the dislocation is limited in this SiC layer and does not propagate to the other SiC layers and the InₓAl_{y}Ga_{(1-x-y)}N layers formed over this SiC layer, thus decreasing the dislocation density in the buffer layer 102.

Moreover, since the lattice mismatch between the buffer layer 102 and the semiconductor layer 104 is small, the stress issue between the silicon substrate 100 and the semiconductor layer 104 may be solved. For example, the lattice mismatch between the SiC layer and the GaN semiconductor layer is merely 3.3%, and the lattice mismatch between the SiC layer and the silicon substrate 100 is smaller than 1%. In comparison, the lattice mismatch between the silicon substrate 100 and the GaN semiconductor layer is about 16%. Therefore, the buffer layer 102 may greatly reduce the lattice mismatch and promote the quality of the first semiconductor layer 104 formed over the buffer layer 102.

Next, still referring to Fig. 1, the first semiconductor layer 104 is disposed over the buffer layer 102 and having a first conductive type. The first semiconductor layer 104 may include, but is not limited to, doped or undoped GaN, InN, AlN, InₓGa₍₁₋ₓ₎N, AlₓIn₎₁ₓ₎N, AlₓIn_{y}Ga_{(1-x-y)}N or any other suitable materials, wherein 0 ≤x ≤ 1, 0 ≤ y ≤ 1 and 0 ≤ (x+y) ≤ 1. The first semiconductor layer 104 may be a P-type semiconductor layer or an N-type semiconductor layer, and may be formed by molecular beam epitaxy (MBE), metalorganic chemical vapor deposition (MOCVD), hydride vapor phase epitaxy (HVPE), liquid phase epitaxy or any other suitable epitaxy process.

Still referring to Fig. 1, an active layer 106 is disposed over the first semiconductor layer 104. The active layer 106 may include, but is not limited to, homojunction, heterojunction, single-quantum well (SQW), multiple-quantum well (MQW) or any other suitable structures. In some embodiments of the present disclosure, the active layer 106 may include undoped N-type InₓGa₍₁₋ₓ₎N. In some embodiments of the present disclosure, the active layer 106 may include other materials such as AlₓIn_{y}Ga_{(1-x-y)}N. Moreover, the active layer 106 may include a multiple-quantum well structure with multiple-quantum layers (such as InGaN) and barrier layers (such as GaN) arranged alternately. Moreover, the active layer 106 may be formed by metalorganic chemical vapor deposition (MOCVD), molecular beam epitaxy (MBE), hydride vapor phase epitaxy

(HVPE), liquid phase epitaxy (LPE) or any other suitable chemical vapor deposition process. In some embodiments of the present disclosure, the active layer 106 completely covers the first semiconductor layer 104. In other embodiments, the active layer 106 covers a portion of the first semiconductor layer 104. The total thickness of the active layer 106 may range from about 5nm to 400nm.

Still referring to Fig. 1, a second semiconductor layer 108 is disposed over the active layer 106 and has a second conductive type different from the first conductive type. The second semiconductor layer 108 may include, but is not limited to, doped or undoped GaN, InN, AlN, InₓGa₍₁₋ₓ₎N, AlₓIn₍₁₋ₓ₎N, AlₓIn_{y}Ga_{(1-x-y)}N or any other suitable materials, wherein 0 ≤x ≤ 1, 0 ≤ y ≤ 1 and 0 ≤ (x+y) ≤ 1. The second semiconductor layer 108 may be P-type semiconductor layer or N-type semiconductor layer, and may be formed by molecular beam epitaxy (MBE), metalorganic chemical vapor deposition (MOCVD), hydride vapor phase epitaxy (HVPE), liquid phase epitaxy or any other suitable epitaxy process.

In some embodiments of the present disclosure, the first semiconductor layer 104 is an N-type semiconductor layer and the second semiconductor layer 108 is a P-type semiconductor layer. The buffer layer 102 is an N-type buffer layer 102 and may further include N-doped SiC layers and Si-doped InₓAl_{y}Ga_{(1-x-y)}N layers. The N doping concentration of the N-doped SiC layers and the Si doping concentration of the Si-doped InₓAl_{y}Ga_{(1-x-y)}N layers may independently range from about 10¹⁵/cm³ to 10²⁰/cm³, for example, from about 10¹⁷/cm³ to 10²⁰/cm³.

In other embodiments of the present disclosure, the first semiconductor layer 104 is a P-type semiconductor layer and the second semiconductor layer 108 is an N-type semiconductor layer. The buffer layer 102 is a P-type buffer layer 102 and may further include Al-doped or B-doped SiC layers and Mg-doped InₓAl_{y}Ga_{(1-x-y)}N layers. The Al or B doping concentration of the Al-doped or B-doped SiC layers and the Mg doping concentration of the Mg-doped InₓAl_{y}Ga_{(1-x-y)}N layers may independently range from about 10¹⁵/cm³ to 10²⁰/cm³, for example, from about 10¹⁸/cm³ to 2x10²⁰/cm³.

Still referring to Fig. 1, the light-emitting diode 50 may further include a first electrode 110 and a second electrode 112. The first electrode 110 is electrically connected to the first semiconductor layer 104, and the second electrode 112 is electrically connected to the second semiconductor layer 108. The first electrode 110 may be disposed at any position that may electrically connect to the first semiconductor layer 104. In some embodiments of the present disclosure, as illustrated in Fig. 1, portions of the active layer 106 and the second semiconductor layer 108 are removed first to expose a portion of the first semiconductor layer 104, then the first electrode 110 is formed over the exposed portion of the first semiconductor layer 104. The second electrode 112 may be disposed at any position that may electrically connect to the second semiconductor layer 108. The second electrode 112 may be a single electrode or a plurality of electrodes. For example, as illustrated in Fig. 1, the second electrode 112 is a single electrode and is disposed over the second semiconductor layer 108.

The first electrode 110 and the second electrode 112 may independently include a single-layer or multiple layers of Au, Cr, Ni, Pt, Ti, Al, Ir, Rh, a combination thereof, or other metal materials with good conductivity. The first electrode 110 and the second electrode 112 may be formed by depositing and patterning processes.

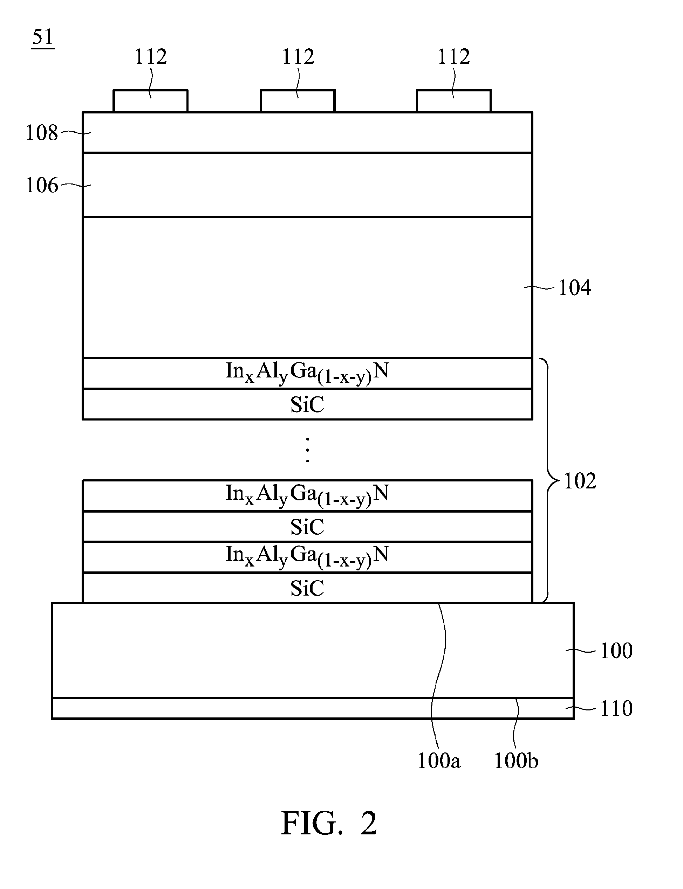

Moreover, although all the aforementioned embodiments use a horizontal light-emitting diode as an example, the present disclosure may also be applied to light-emitting diodes of other types, such as a vertical light-emitting diode. For example, in some embodiments of the present disclosure, as illustrated in Fig. 2, the first electrode 110 is disposed over the second surface 100b of the silicon substrate 100. Moreover, as illustrated in Fig. 2, the second electrode 112 over the second semiconductor layer 108 is a plurality of electrodes and the buffer layer 102 may cover a portion of the silicon substrate 100.

In summary, the light-emitting diode provided in the present disclosure utilizes a Si substrate, and therefore it is cost-effective and the heat produced may effectively be exhausted to facilitate mass production. When it is applied to the high power light-emitting diode, the power of the high power light-emitting diode will not decrease due to the over accumulation of heat at the substrate. Moreover, the light-emitting diode provided in the present disclosure also utilizes a buffer layer having high reflectivity and high buffer ability to effectively solve the issues of the difference of the thermal expansion coefficients between the silicon substrate and the semiconductor layer, the lattice mismatch, and the absorbance of a portion of the blue light emitted from the light-emitting diode by the silicon substrate. Furthermore, since no removal of the silicon substrate is needed, the present disclosure can be applied to the horizontal light-emitting diode.

Although some embodiments of the present disclosure and their advantages have been described in detail, it should be understood that various changes, substitutions and alterations can be made herein without departing from the spirit and scope of the disclosure as defined by the appended claims. For example, it will be readily understood by those skilled in the art that many of the features, functions, processes, and materials described herein may be varied while remaining within the scope of the present disclosure. Moreover, the scope of the present application is not intended to be limited to the particular embodiments of the process, machine, manufacture, composition of matter, means, methods and steps described in the specification. As one of ordinary skill in the art will readily appreciate from the disclosure of the present disclosure, processes, machines, manufacture, compositions of matter, means, methods, or steps, presently existing or later to be developed, that perform substantially the same function or achieve substantially the same result as the corresponding embodiments described herein may be utilized according to the present disclosure. Accordingly, the appended claims are intended to include within their scope such processes, machines, manufacture, compositions of matter, means, methods, or steps.

## Claims

1. A light-emitting diode (50), comprising:
a silicon substrate (100) having a first surface (100a) and a second surface
(100b) opposite to the first surface (100a);
a buffer layer (102) disposed over the first surface (100a) of the substrate,
wherein the buffer layer (102) comprises alternating SiC and InₓAl_{y}Ga_{(1-x-y)}N layers, wherein 0 ≤ x ≤ 1, 0 ≤ y ≤ 1, and 0 ≤ (x+y) ≤ 1 and one of the SiC layers directly contacts the substrate;
a first semiconductor layer (104) disposed over the buffer layer (102) and
having a first conductive type;
an active layer (106) disposed over the first semiconductor layer (104); and
a second semiconductor layer (108) disposed over the active layer (106) and
having a second conductive type different from the first conductive type.

2. The light-emitting diode (50) as claimed in claim 1, wherein the buffer layer (102) comprises 5-20 pairs of the alternating SiC and InₓAl_{y}Ga_{(1-x-y)}N layers.

3. The light-emitting diode (50) as claimed in claim 1, wherein the buffer layer (102) comprises N-doped SiC layers and Si-doped InₓAl_{y}Ga_{(1-x-y)}N layers and the buffer layer (102) is an N-type buffer layer (102), wherein the first semiconductor layer (104) is an N-type semiconductor layer and the second semiconductor layer (108) is a P-type semiconductor layer.

4. The light-emitting diode (50) as claimed in claim 3, wherein N doping concentration of the N-doped SiC layers and Si doping concentration of the Si-doped InₓAl_{y}Ga_{(1-x-y)}N layers independently range from 10¹⁷/cm³ to 10¹⁹/cm³.

5. The light-emitting diode (50) as claimed in claim 1, wherein the buffer layer (102) comprises Al-doped or B-doped SiC layers and Mg-doped InₓAl_{y}Ga_{(1-x-y)}N layers and the buffer layer (102) is a P-type buffer layer (102), wherein the first semiconductor layer (104) is a P-type semiconductor layer and the second semiconductor layer (108) is an N-type semiconductor layer.

6. The light-emitting diode (50) as claimed in claim 5, wherein doping concentrations of Al, B and Mg independently range from 10¹⁸/cm³ to 10²⁰/cm³.

7. The light-emitting diode (50) as claimed in claim 1, wherein reflectivity of the buffer layer (102) range from 80% to 100%.

8. The light-emitting diode (50) as claimed in claim 1, further comprising:
a first electrode (110) disposed over the first semiconductor layer (104); and
a second electrode (112) disposed over the second semiconductor layer (108).

9. The light-emitting diode (50) as claimed in claim 1, further comprising:
a first electrode (110) disposed over the second surface (100b) of the silicon
substrate (100); and
a second electrode (112) disposed over the second semiconductor layer (108).

10. The light-emitting diode (50) as claimed in claim 9, comprising a plurality of the second electrodes (112).
